# EUROPEAN PATENT SPECIFICATION

(11) **EP 1 866 235 B1**
(45) Date of publication and mention of the grant of the patent: **21.09.2011**
(21) Application number: 06808916.8
(22) Date of filing: 18.03.2006
(51) Int. Cl.: H01H 61/04, B81B 7/02, B81B 3/00, H01H 37/32, H01H 9/20, H01H 37/46

(54) **MEMS ACTUATORS AND SWITCHES**
MEMS-AKTUATOREN UND -SCHALTER
ACTIONNEURS ET COMMUTATEURS MEMS

(30) Priority: 18.03.2005 US 662829 P; 18.03.2006 US 308358
(43) Date of publication of application: 19.12.2007
(73) Proprietor: Réseaux MEMS, Montreal QC H4Z 1E9 (CA)
(72) Inventor: LU, Jun, Dorval, Quebec H9P 1H7 (CA); MENARD, Stephane, Dorval, Quebec H9P 1H7 (CA)
(74) Representative: Le Forestier, Eric
(86) International application number: PCT/IB2006/002728
(87) International publication number: WO 2007/007206

(56) References cited:
- EP-A2- 1 426 992
- WO-A-03/088292
- WO-A2-03/041133
- GB-A- 2 410 371
- US-A1- 2002 021 053
- US-A1- 2003 038 703
- US-A1- 2004 211 178
- US-B1- 6 433 657
- US-B2- 6 777 629

## Description

### FIELD OF THE INVENTION

This application relates generally to the field of microelectromechanical systems (MEMS) and in particular to improved MEMS devices that do not require additional current limiting devices.

### BACKGROUND OF THE INVENTION

Microelectromechanical systems (MEMS) are small, movable, mechanical structures built using well-characterized, semi-conductor processes. Advantageously, MEMS can be provided as actuators, which have proven to be very useful in many applications.

Present-day MEMS actuators quite small, having a length of only a few hundred microns, and a width of only a few tens of microns. Such MEMS actuators are typically configured and disposed in a cantilever fashion. In other words, they have an end attached to a substrate and an opposite free end which is movable between at least two positions, one being a neutral position and the others being deflected positions.

Electrostatic, magnetic, piezo and thermal actuation mechanisms are among the most common actuation mechanisms employed MEMS. Of particular importance is the thermal actuation mechanism.

As is understood by those skilled in the art, the deflection of a thermal MEMS actuator results from a potential being applied between a pair of terminals, called "anchor pads", which potential causes a current flow elevating the temperature of the structure. This elevated temperature ultimately causes a part thereof to contract or elongate, depending on the material being used.

One possible use for MEMS actuators is to configure them as switches. These switches are made of at least one actuator. In the case of multiple actuators, they are typically operated in sequence so as to connect or release one of their parts to a similar part on the other. These actuators form a switch which can be selectively opened or closed using a control voltage applied between corresponding anchor pads on each actuator.

MEMS switches have many advantages. Among other things, they are very small and relatively inexpensive - depending on the configuration. Because they are extremely small, a very large number of MEMS switches can be provided on a single wafer.

Of further advantage, MEMS switches consume minimal electrical power and their response time(s) are extremely short. Impressively, a complete cycle of closing or opening a MEMS switch can be as short as a few milliseconds.

Although prior-art MEMS actuators and switches have proven to be satisfactory to some degree, there nevertheless remains a general need to further improve their performance, reliability and manufacturability. For instance, one factor which generally increases the overall costs of a system using MEMS switches is the inclusion of any additional protection that is oftentimes required in particular markets.

One such type of additional protection that raises the cost of a MEMS based systems is a current limiter device. These current limiters are external devices that protect each MEMS switch from being damaged by a relatively large current peak occurring in one of the circuits. Such current peaks - while usually brief in length - can damage unprotected MEMS switches. Eliminating the need for numerous current limiters in MBMS based systems would significantly decrease the overall costs of these systems and represent a significant advance in the art.

In this technical field, the document 2004/211178 A1 concerns MEMS cantilever actuator mounted on a substrate, the actuator comprising:
- an elongated hot arm member having two spaced-apart portions, each provided at one end with a corresponding anchor pad connected to the substrate, the portions being connected together at a common end that is opposite the anchor pads;
- an elongated cold arm member adjacent and substantially parallel to the hot arm member, the cold arm member having at one end an anchor pad connected to the substrate, and a free end that is opposite the anchor pad thereof; and
- a dielectric tether attached over the common end of the portions of the hot arm member and the free end of the cold arm member to mechanically couple the hot arm member and the cold arm member and keep them electrically independent.

### SUMMARY OF THE INVENTION

We have developed improved MEMS structures employing movable conductive member and a number of current-carrying stationary contact terminals which advantageously permits higher current carrying capability that prior art devices in which currents flowed through movable conductive members. Advantageously, and in sharp contrast to the prior art , our inventive structures according to claims 1 and 12 may carry currents in excess of 1.0 amp without the need for additional current limiting devices. Consequently, systems employing our inventive structures exhibit significantly lower overall system manufacturing costs.

### BRIEF DESCRIPTION OF THE DRAWING

A more complete understanding of the present invention may be realized by reference to the accompanying drawing in which:
**FIG I** is a schematic of an exemplary MEMS switch according to the present invention;
**FIGS 2a** and **2b** are side views of actuators employed by the MEMS switch of **FIG 1**;
**FIGS 3a - 3e** show schematically an example of the relative movement of the MEMS actuators of **FIGS 2a** and **2b** when they go from "open" to "closed" position;
**FIG 4** shows a schematic of an alternate embodiment of the exemplary MEMS switch of **FIG 1****;**
**FIG 5** shows a schematic of another alternate embodiment of the exemplary MEMS switch of **FIG 1****;**
**FIG 6a - 6c** show a schematic of yet another alternate embodiment of the exemplary MEMS switch of **FIG 1**;
**FIG 7** shows a schematic of yet another alternate embodiment of the exemplary MEMS switch of **FIG 1** wherein four sets of contact terminals are employed;
**FIG 8** is a schematic of yet another alternate embodiment of the MEMS switch of **FIG 1** wherein one actuator is provided with a second hot arm member;
**FIG 9** is a schematic of another alternate embodiment of the MEMS switch of **FIG 1** employing a single hot arm member;
**FIG 10** is a schematic of another alternate embodiment of the MEMS switch of **FIG 1**;
**FIG 11** is a left-side view of the embodiment of **FIG 10**;
**FIG 12** is a cross-sectional view of the embodiment of **FIG 10**;
**FIG 13a -13e** show the sequence of operation of the MEMS switch of **FIG 10**;
**FIG 14** shows a schematic of an alternative embodiment of the MEMS switch of **FIG.10**;
**FIG 15a -15e** show the sequence of operation of the MEMS switch of **FIGS 14**;
**FIG 16** shows a schematic of another alternative embodiment of the MEMS switch of **FIG 1**;
**FIG 17** is a side-view of the MEMS switch of **FIG 16**; and
**FIG 18** is a cross-sectional view of the MEMS switch of **FIG 17**.

### DETAILED DESCRIPTION

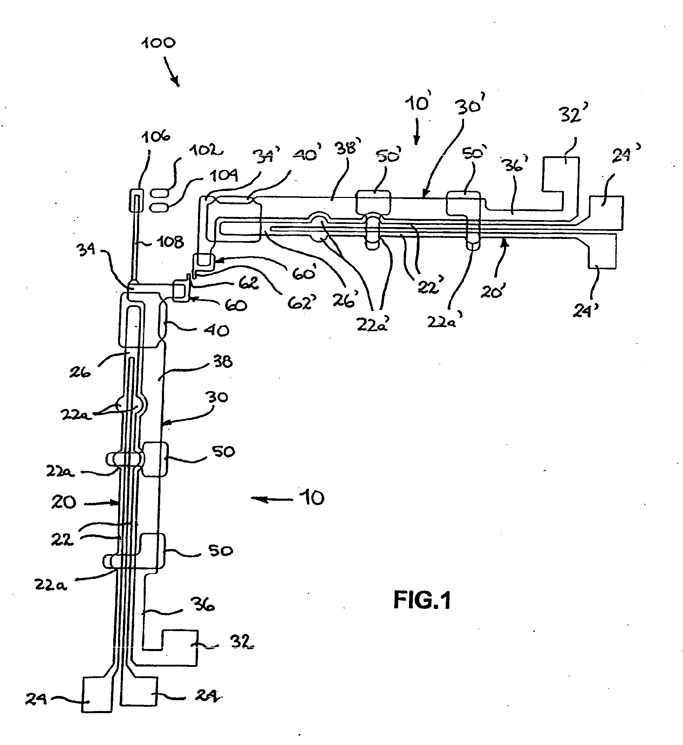

**FIG. 1** shows an example of a MEMS switch (**100**) constructed according to the principles of the present invention. The switch (**100**) comprises two MEMS actuators (**10, 10'**). The MEMS switch (**100**) is used to selectively close or open a circuit between a pair of contact terminals (**102, 104**) using a movable conductive member (**106**) mounted at the end of a support arm (**108**).

In accordance with a possible embodiment of the invention, at least two support arms are provided on the same one of the MEMS actuator.

When the MEMS switch **(100)** is in a closed position, the contact terminals (102, **104**) are in electrical engagement - that is to say an electrical current may flow between the two contact terminals (**102,104**). This electrical engagement is realized when the movable conductive member (106) electrically "shorts" the pair of contact terminals (**102,104**).

Conversely, when the MEMS switch (**100**) is in an open position, the contact terminals (**102, 104**) are not electrically engaged and no appreciable electrical current flows between them. In preferred embodiments, the movable conductive member (**106**) is gold plated.

We have discovered that that using contact terminals (**102, 104**) such as those shown and a movable conductive member (**106**) allows the conducting of higher currents than MEMS devices in which an electrical conducting path goes along a length of the MEMS actuators (**10, 10'**) themselves. Advantageously, and as a direct result of our inventive MEMS structure (**100**), it is now possible to employ MEMS switches while - at the same time - avoid using current limiters. As a result, overall manufacturing costs of systems employing MEMS switches may be significantly reduced.

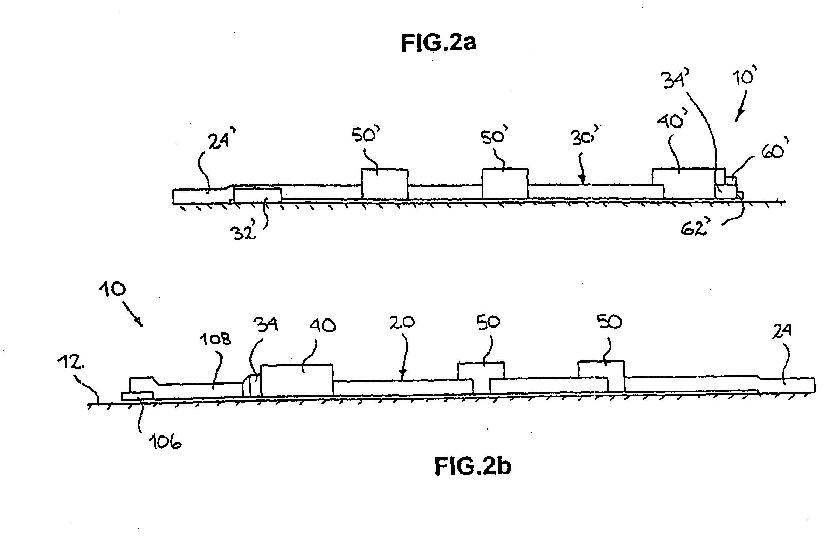

Turning our attention now to **FIGS. 2a** and **2b****,** there is shown side views of the actuators (**10, 10'**) of **FIG.1** which are mounted on a substrate (**12**) in a cantilever fashion. One example of the substrate (**12**) is a silicon wafer - a very well characterized substrate. As can be readily appreciated by those skilled in the art however, our invention is not limited to silicon substrates.

Referring back to **FIG. 1****,** each of the actuators (**10,10'**) comprises an elongated hot arm member (**20, 20'**) having two spaced-apart portions (**22, 22'**). Each spaced-apart portion (**22, 22'**) is provided at one end with a corresponding anchor pad (**24, 24'**) connected to the substrate (**12**).

In each actuator (**10, 10'**), the spaced-apart portions (**22, 22'**) are substantially parallel and connected together at a common end (**26, 26'**) that is shown opposite the anchor pads (**24, 24'**) and overlying the substrate (**12**).

Each of the actuators (**10, 10'**) also comprises an elongated cold arm member (**30, 30'**) adjacent and substantially parallel to the corresponding hot arm member (**20, 20'**). The cold arm member (**30, 30'**) has, at one end, an anchor pad (**32, 32'**) connected to the substrate (**12**) and a free end (**34, 34'**) that is shown opposite the anchor pad thereof (**32, 32'**). The free end (**34, 34'**) is overlying the substrate (**12**).

A dielectric tether (**40, 40'**) is attached over the common end (**26, 26'**) of the portions (**22, 22'**) of the hot arm member (**20, 20'**) and over the free end (**34, 34'**) of the cold arm member (**30, 30'**). The dielectric tether (**40, 40'**) is provided to mechanically couple the hot arm member (**20, 20'**) and the cold arm member (**30, 30'**) and to keep them electrically independent, thereby maintaining them in a spaced-apart relationship with a minimum spacing between them to avoid a direct contact or a short circuit in normal operation as well as to maintain the required withstand voltage, which voltage is proportional to the spacing between the corresponding members (**20, 30** and **20', 30'**).

It should be noted that maximum used voltage can be increased by changing of the ambient atmosphere. For instance, the use of high electro-negative gases as ambient atmosphere would increase the withstand voltage. One example of this type of gases is Sulfur Hexafluoride, SF₆.

The dielectric tether (**40, 40'**) is preferably molded directly in place at the desired location and is attached by direct adhesion. Direct molding further allows having a small quantity of material entering the space between the parts before solidifying. Advantageously, the dielectric tether (40, 40') may be attached to the hot arm member (**20, 20'**) and the cold arm member (**30, 30'**) in a different manner than the one shown in the figures. Moreover, the dielectric tethers (**40, 40'**) can be transparent as illustrated in some of the figures.

Each dielectric tether (**40, 40'**) is preferably made entirely of a photoresist material. It was found that a very suitable material for that purpose, which is also easy to manufacture, is the material known in the trade as "SU-8". The SU-8 is a negative, epoxy-type, near-UV photo resist based on EPON SU-8 epoxy resin (from Shell Chemical). Of course, other photoresist may be used as well, depending upon the particular design requirements. Other possible suitable materials include polyimide, spin on glass, oxide, nitride, ORMOCORE™, ORMOCLAD™ or other polymers. Moreover, combining different materials is also possible and well within the scope of the present invention. As can be appreciated, providing each dielectric tether (**40, 40'**) over the corresponding actuator (**10, 10'**) is advantageous because it allows using the above-mentioned materials, which in return provides more flexibility on the tether material and a greater reliability.

In use, when a control voltage is applied at the anchor pads (**24, 24'**) of the hot arm member (**20, 20'**), a current travels into the first and second portions (**22, 22'**). In the various embodiments illustrated herein, the material(s) comprising the hot arm members (**20, 20'**) is a substantially conductive material selected so that it increases in length as it is heated. The cold arm members (**30, 30'**), however, do not substantially exhibit such elongation since no current is initially passing through them. The result of this arrangement is that when a control voltage is applied at the anchor pads (**24, 24'**), the resulting current flow in the hot arm members (**20, 20'**) results in their heating, and the free end of each actuator (**10, 10'**) is deflected sideward because of the asymmetrical configuration of the parts, thereby moving the actuators (**10, 10'**) from a neutral position to a deflected position. Conversely, removing the control voltage from the anchor pads (**24, 24'**) results in the cooling of the hot arm member (**20, 20'**) thereby causing it to move to its original position. Advantageously, both movements (from neutral to deflected and deflected back to neutral) occur very rapidly.

Preferably, each cold arm member (**30, 30'**) comprises a narrower section (**36, 36'**) adjacent to its anchor pad (**32, 32'**) in order to facilitate the movement between the neutral position and the deflected position. Each narrower section (**36, 36'**) has a width laterally decreased from the exterior compared to a wider section (**38, 38'**) of the cold arm member (**30, 30'**). In the preferred embodiment, the width decrease is at a square angle. As can be appreciated by those skilled in the art, other shapes are possible as well.

Each of the actuators (**10, 10'**) in the embodiment shown in **FIG. 1** includes a set of two spaced-apart additional dielectric tethers (**50, 50'**). These additional dielectric tethers (**50, 50'**) are transversally disposed over the portions (**22, 22'**) of the hot arm member (**20, 20'**) and over the cold arm member (**30, 30'**). Generally, they adhere to these parts.

It is advantageous to provide at least one of these additional dielectric tethers (**50, 50'**) on each actuator (**10, 10'**) so as to provide additional strength to the hot arm member (**20, 20'**) by reducing their effective length, thereby preventing distortion of the hot arm member (**20, 20'**) over time. Since the gap between the parts is extremely small, the additional tethers (**50, 50'**) reduce any risk of a short circuit between the two portions (**22, 22'**) of the hot arm member (**20, 20'**) or between the portion (**22, 22'**) of the hot arm member (**20, 20'**) which is physically the closest to the cold arm member (**30, 30'**) and the cold arm member (3**0, 30'**) itself by keeping them in a spaced-apart configuration.

Additionally, since the cold arm member (**30, 30'**) can be used to carry high voltage signals in some configurations, the portion (**22, 22'**) of the hot arm member (**20, 20'**) closest to the cold arm member (**30, 30'**) may deform, thereby moving closer towards the cold arm member (**30, 30'**) due to the electrostatic force between them created by the high voltage signal. If the portion (**22, 22'**) of the hot arm member (**20, 20'**) gets too close to the cold arm member (**30,30'**), a voltage breakdown can occur, destroying the MEMS switch (**100**). Finally, since the two portions (**22, 22'**) of the hot arm member (**20, 20'**) are relatively long, they tend to distort when heated to create the deflection, thereby decreasing the effective stroke of the actuators (**10,10'**).

As can be appreciated, using one, two or more additional dielectric tethers (50, 50') has many advantages, including increasing the rigidity of the portions (**22, 22'**) of the hot arm member (**20, 20'**), increasing the stroke of the actuators (**10, 10'**), decreasing the risks of shorts between the portions (**22, 22'**) of the hot arm members (**20, 20'**) and increasing the breakdown voltage between the cold arm members (**30, 30'**) and hot arm members (**20, 20'**).

The additional dielectric tethers (**50, 50'**) are preferably made of a material identical or similar to that of the main dielectric tethers (**40, 40'**). Small quantities of materials are advantageously allowed to flow between the parts before solidifying in order to improve the adhesion. In addition, one or more holes or passageways (not shown) can be provided in the cold arm members (**30, 30'**) to receive a small quantity of material before it solidifies to ensure a better adhesion.

The additional tethers (**50, 50'**) are preferably provided at enlarge points (**22a, 22a'**) along the length of each actuator (**10, 10'**). These enlarged points (**22a, 22a'**) offer a greater contact surface and also contribute to dissipate more heat when a current flows therein. Providing a larger surface and allowing more heat to be dissipated increase the actuator life time

Continuing with our discussion of **FIG. 1**, it may be observed that this figure further shows that each actuator (**10, 10'**) of the preferred embodiment comprises a corresponding tip member (**60, 60'**) attached to the free end (**34, 34'**) of the cold arm member (**30, 30'**). In this configuration, the tip members (**60, 60'**) are used to perform a mechanical latch enabling the MEMS switch (**100**) to remain in its "on" positions without requiring power. In some other configurations where we need to create an electrical connection between the tip members (**60, 60'**), the surface of the contact flanges (**62, 62'**) of each tip member (**60, 60'**) is preferably designed so as to lower the contact resistance when two of such tip members (**60, 60'**) make contact with each other. This can be obtained by using tip members (**60, 60'**) made of gold, either entirely made of gold or gold-over plated. Other possible materials include a gold-cobalt alloy, palladium, etc. Such materials provide a lower contact resistance in comparison with nickel, which is the preferred material for the cold arm members (**30, 30'**). The hot arm members (**20, 20'**) are also preferably made of nickel. Other materials can be used for the hot arm members (**20, 20'**) and the cold arm members (**30, 30'**).

Turning our attention now to **FIG. 2a****,** there it shows that the tip member (**60'**) of one actuator (**10'**) is attached under the free end (**34, 34'**) of the corresponding cold arm member (**30, 30'**). Preferably, it is attached using the natural adhesion of the materials when plated over each other, although other means can be used as well. If the tip members (**60, 60'**) are made of Nickel then it would be built simultaneously with the Nickel cold and hot arms and would therefore be an integral part of the cold arm member (**30, 30'**).

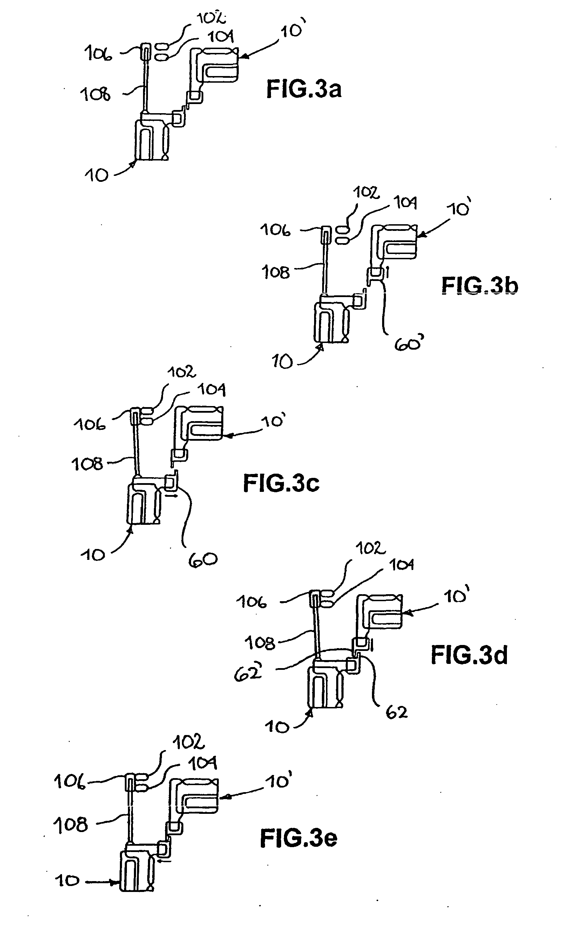

**FIGS. 3a** through **3e** schematically show an example of the relative movement of the MEMS actuators (**10, 10'**) when the MEMS switch (**100**) goes from an "open position" to a "closed position", thereby closing the circuit between the two contact terminals (**102, 104**). To move from one position to the other, the actuators (**10, 10'**) are operated in sequence.

More particularly, **FIG. 3a** shows the initial position of the MEMS switch (**100**). In **FIG. 3b****,** the hot arm member of the second actuator (**10'**) is activated so that the tip member (**60'**) is deflected to its right. Then, in **FIG. 3c**, the tip member (**60**) of the first actuator (**10**) is deflected to its right upon activation of the corresponding hot arm member.

**FIG. 3d** shows the control voltage in the second actuator (**10'**) being released, which causes its flange (**62'**) to engage the back side of the flange (**62**) of the first actuator (**10**) as it returns towards its neutral position. Then, in **FIG. 3e****,** the control voltage of the first actuator (**10**) is subsequently released, thereby allowing a stable engagement between both actuators (**10, 10'**). The closing of the MEMS switch (**100**) is very rapid, all this occurring in typically a few milliseconds. Advantageously, the MEMS switch (**100**) can be opened by reversing the above-operations.

As can be seen, the movable conductive member (**106**) is moved, in FTG. 3a to **FIG. 3e****,** from a position where it is out of engagement with the contact terminals (**102, 104**), to a position where it is urged against the contact terminals (**102, 104**) such that a circuit is closed. The support arm (**108**) is slightly bent when the circuit is closed, this creating a spring force which maintains the conductive member (**106**) in a good positive engagement. A signal or simply a current can then be transmitted between both corresponding contact terminals (**102, 104**). It should be noted at this point that if required, the MEMS actuators (**10, 10'**) can still be used to transmit a signal through their own structure, although this path would not be as optimum as the one between the two contact terminals (**102, 104**). In that case, the free end (**34**) would include a dielectric tether to electrically insulate the support arm (**108**) and the actuator (**10**).

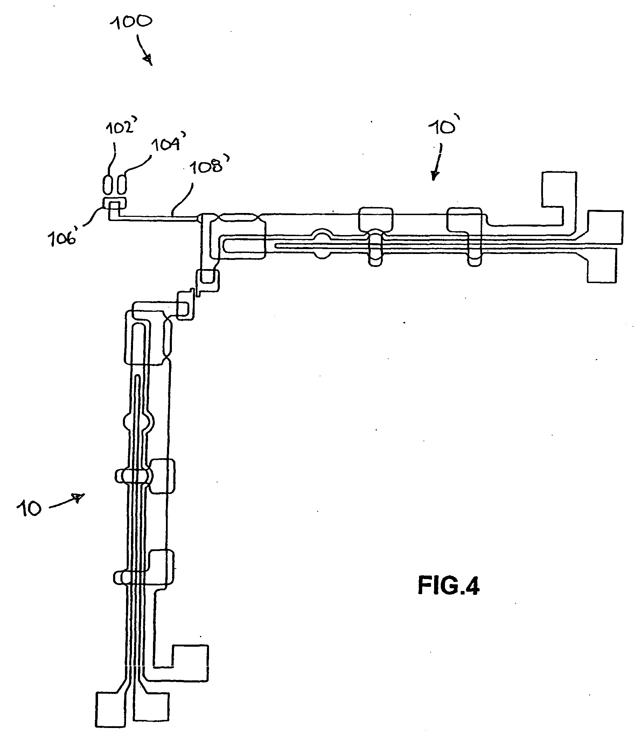

**FIG. 4** illustrates an alternate embodiment. This embodiment is similar to the one illustrated in **FIG. 1**, with the exception that it comprises a movable conductive member (**106'**) to engage contact terminals (**102', 104'**) and a corresponding support arm (**108'**) mounted on the second actuator (**10'**).

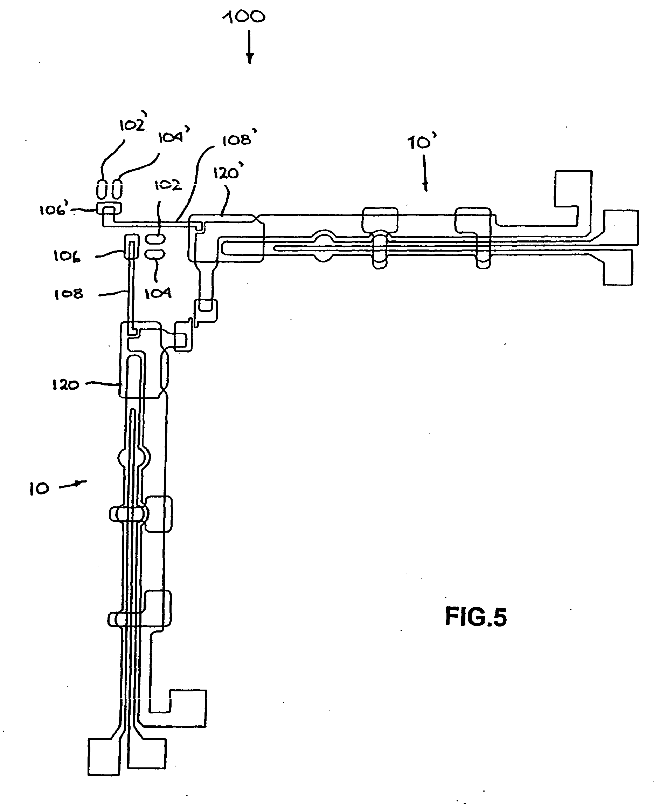

**FIG. 5** illustrates another alternate embodiment of our inventive MEMS switch structure. It comprises the two movable conductive members (**106, 106'**) and the two corresponding support arms (**108, 108'**). When closed, this MEMS switch (**100**) simultaneously creates two circuits. In this embodiment, a dielectric tether (**120, 120'**) is provided between each free end (**34, 34'**) and the corresponding support arms (**108, 108'**) to electrically insulate each contact.

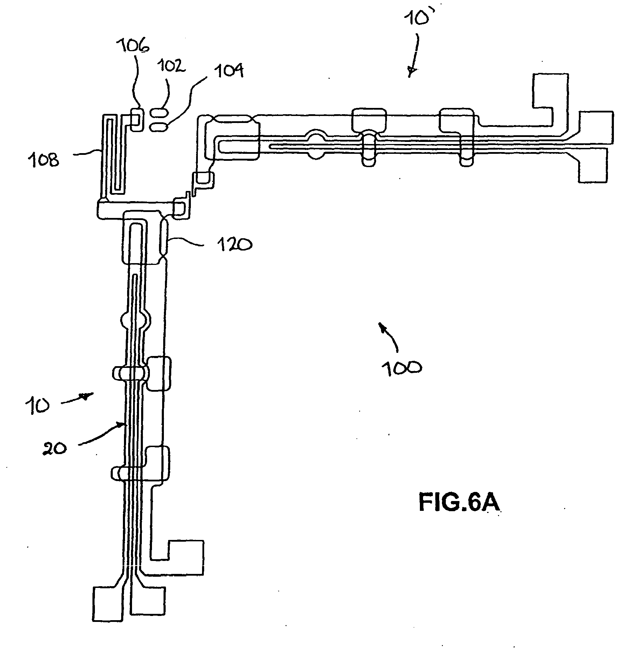

**FIG. 6A** illustrates a further alternate embodiment. It comprises a movable conductive member (**106**) being located at the end of a support arm (**108**) having a plurality of parallel segments. This spring-like configuration provides more flexibility to the support arm (**108**) when the movable conductive member (**106**) abuts on the two contact terminals (**102, 104**). As can be readily appreciated, flexibility may have an effect on contact resistance and life cycle.

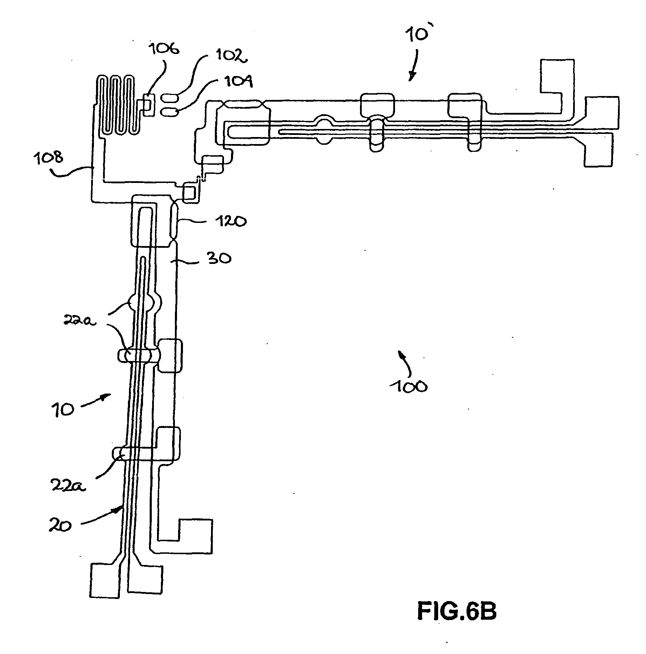

**FIG. 6B** shows a variation of the embodiment shown in **FIG. 6A****.** One of the MEMS actuators (**10, 10'**) of the switch (**100**) has a hot arm member (**20**) being set at an angle with reference to the cold arm member (**30**). Advantageously, this angular offset provides some compensation for the supplemental stress exerted by the support arm (**108**) on the dielectric tether (**120**) when the MEMS switch (**100**) is closed.

In addition, this angular offset also prevents the actuator (**10**) from moving away from its original position after many cycles - as a result of fatigue. Without the angle on the hot arm member (**20**), the gap between the movable contact member (**106**) and the contact terminals (**102, 104**) may gradually increase over time with repeated cycling. As can be readily appreciated, the angle provides a greater lateral stability to the actuator (**10**).

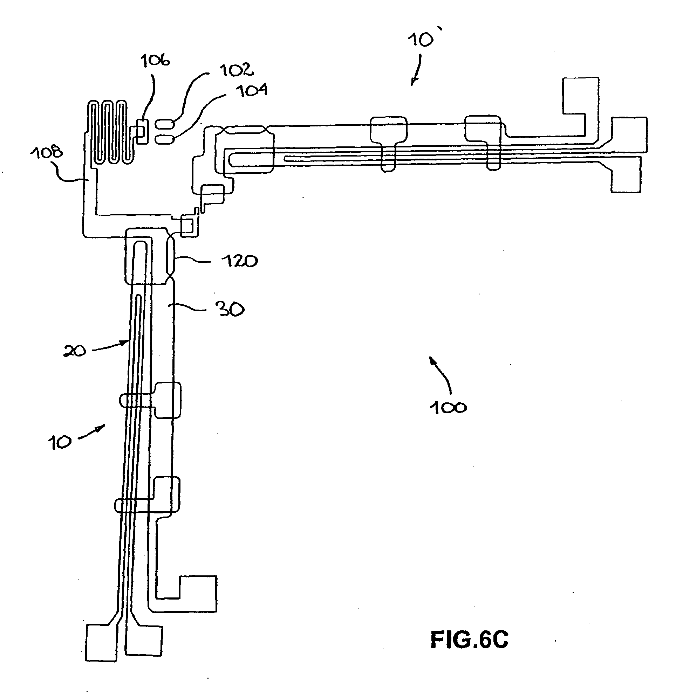

Preferably, the support arm (**108**) is made integral with the cold arm member (30) and is designed with a rigid base portion and a spring-like portion somewhat symmetrically disposed around a central axis extending towards and between the contact terminals (**102, 104**). **FIG. 6C** shows a variation of the structure shown in **FIG. 6B****,** whereby the actuators (**10,10'**) are not provided with enlarged points (**22a, 22a'**).

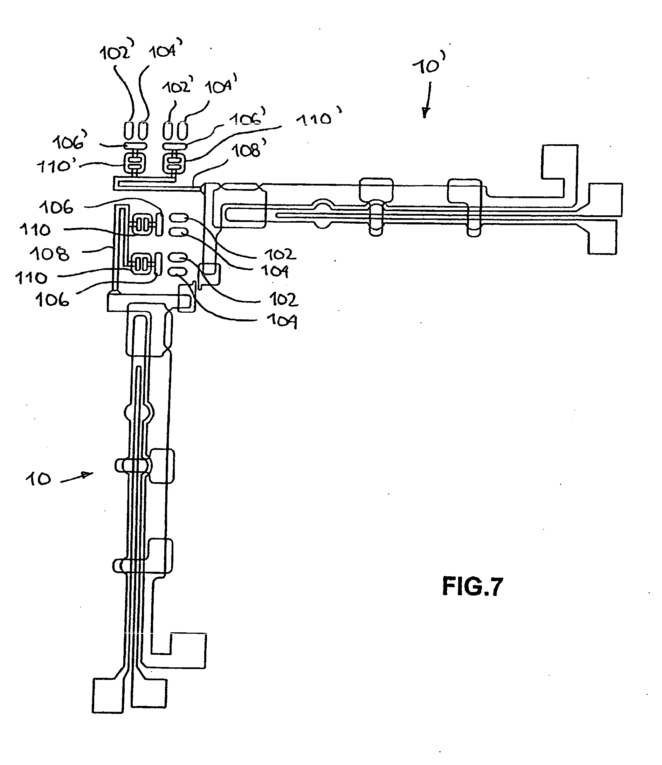

**FIG. 7** shows another alternate embodiment, whereby four sets of contact terminals (**102, 104 and 102', 104'**) are used. Each support arm (**108, 108'**) carries two corresponding movable contact members (**106, 106'**) and is shaped in a spring-like configuration having two substantially parallel segments. Each movable contact member (**106, 106'**) is made electrically independent from the support arm (**108**) by a corresponding tether (**110, 110'**).

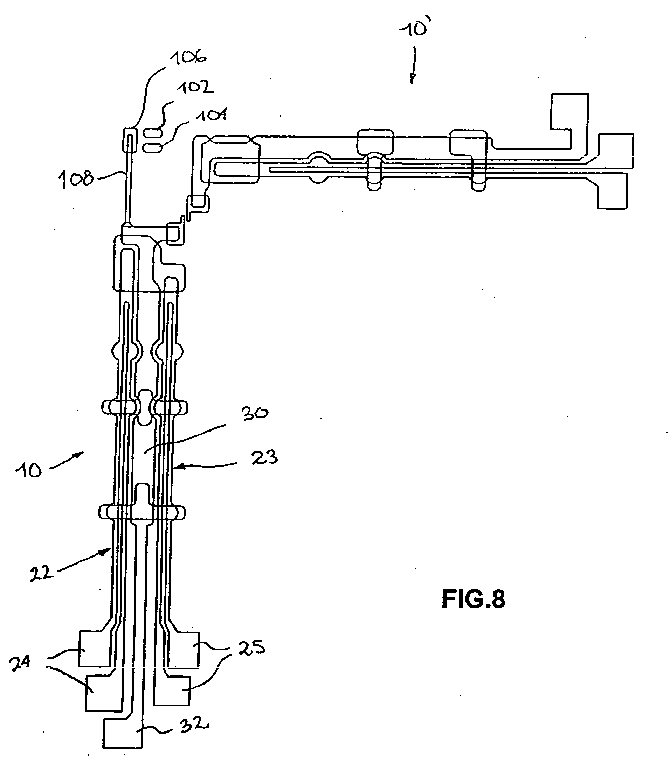

**FIG. 8** shows an alternate embodiment on the MEMS switch (**100**) in which one of the actuators (**10, 10'**) is provided with a second hot arm member (**23**) opposite the first hot arm member (**22**). The second hot arm member (**23**) has two corresponding anchor pads (**25**). This second hot arm member (**23**) is activated during the release of the MEMS switch (**100**) from a closed position to an open position. This may be useful to counteract sticktion forces or micro-weld, if any, that could occur between the movable conductive member (**106**) and the two contact terminals (**102, 104**). If these forces exceed the natural return force when the actuator (**10**) goes back to its initial position, then the second hot arm member (**23**) can provided the additional necessary force on the opposite side to counteract them.

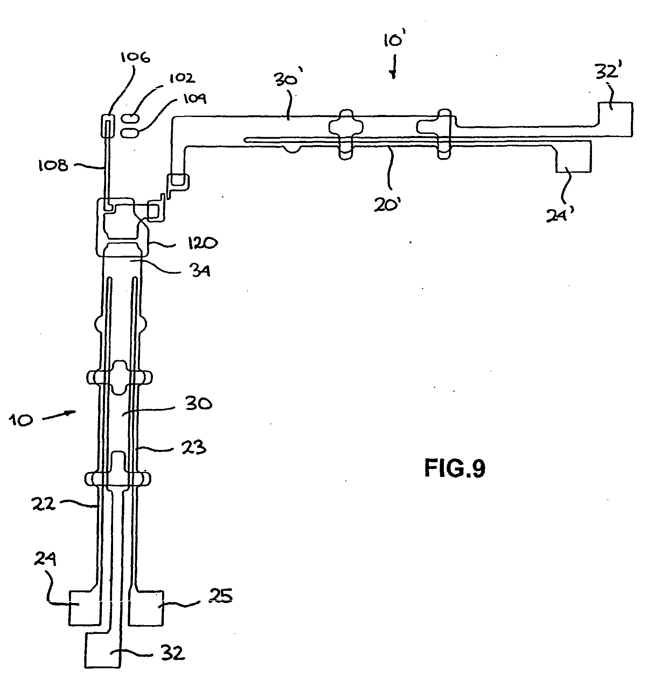

**FIG. 9** illustrates another alternate embodiment in which each actuator (**10, 10'**) are built using single hot arm members instead of dual hot arm members. This configuration reduces the total size and increase the flexibility of the MEMS switch (**100**). On the other hand, a single hot arm member configuration reduce the effective stroke and forces applied to the contact terminals (**102, 104**). One actuator (**10**) has three anchor pads (**24, 25, and 32**) but has two single hot arm members (**22, 23)**, the other actuator (**10'**) has two anchor pads (**24' 32'**) but only a one-portion hot arm member (**20'**) that is directly connected to the cold arm member (**30'**). A dielectric tether (**120**) is provided between free end (**34**) and support arm (**108**) and between free end (**34**) and cold arm member (**30**).

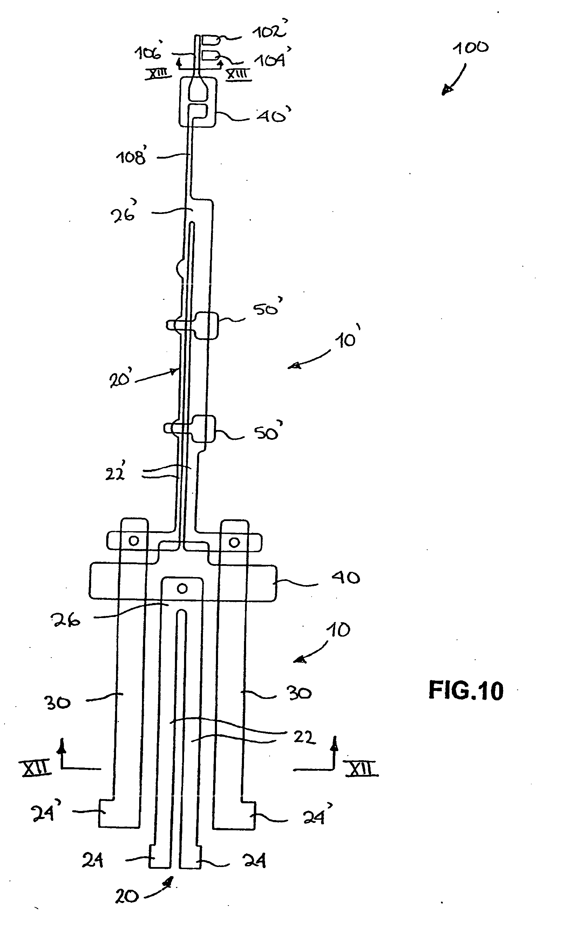

**FIGS. 10** to **18** illustrate a different class of MEMS switches (**100**). In these MEMS switches (**100**), the movable conductive member (**106**) is moved vertically during the process of opening or closing the circuit.

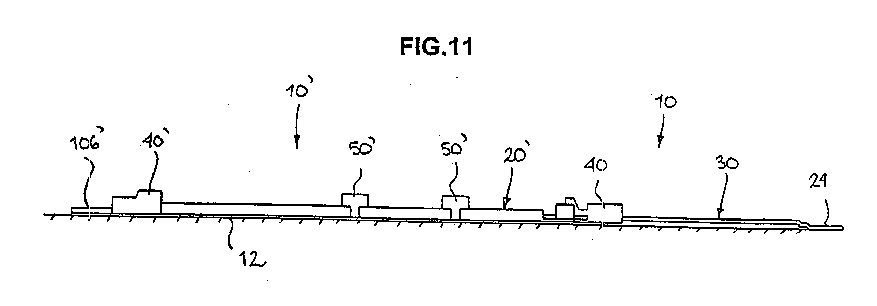

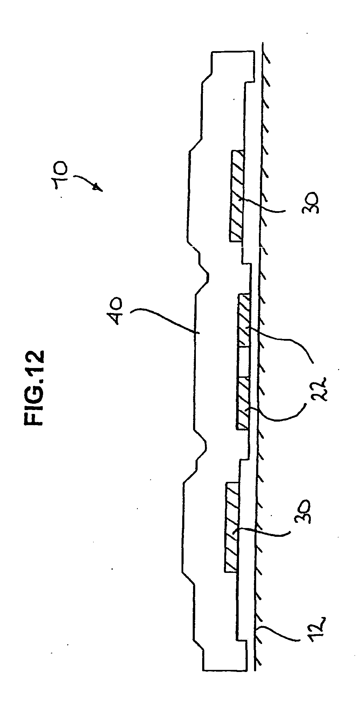

In **FIG. 10****,** the portion closer to the anchor pads (**24, 24'**) is the first actuator (**10**) which moves the second actuator (**10'**) vertically using portions (**22**) of the hot arm member (**20**). The electrical current is supplied to the second actuator (**10'**) through the anchor pads (**24'**) and the arm members (**30**) of the first actuator (**10**). The first and the second actuators (**10, 10'**) are connected together by means of a tether (**40**). When activated, the portions (**22'**) of the hot arm member (**22**) of the second actuator (**10'**) moves the support arm (**108'**) and the movable conductive member (**106'**) to the right. The support arm (**108'**) is electrically insulated from the movable conductive member (106') by means of a tether (**40'**). **FIG. 11** is a left side view of this arrangement. **FIG. 12** is a cross-sectional view taken along line XII-XII in **FIG. 10****.**

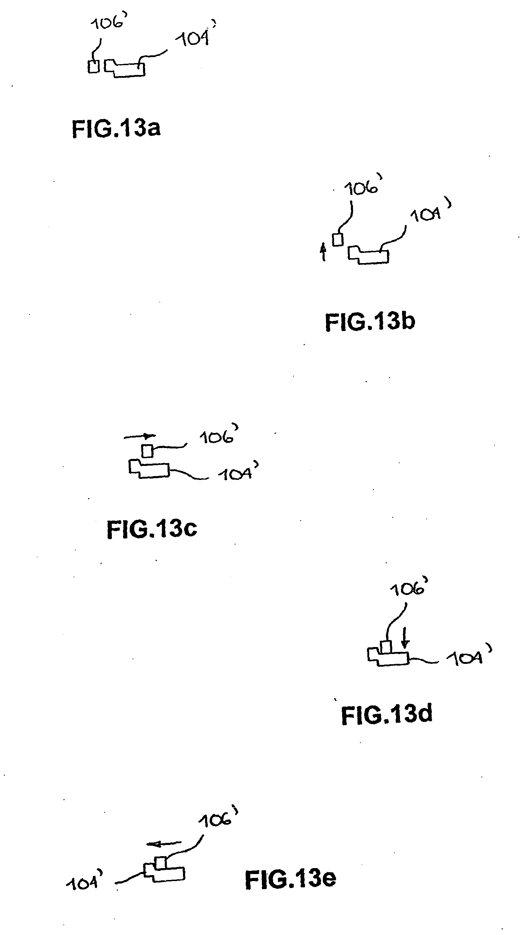

**FIGS. 13a** to **13e** show the sequence of operation of the MEMS switch (**100**) of FIGS. 10 to **12**, as viewed from line XIII-XIII in **FIG. 10****.** The initial "open" position is shown in **FIG. 13a. FIG. 13b** shows the movable conductive member (**106'**) being raised as the first actuator is activated. When the first actuator is activated, its hot arm member is heated by an electric current flowing therein. This increases the length of the hot arm member. Since the hot arm member (**20**) is slightly vertically offset with reference to the cold arm members (**30**), as shown in **FIG. 12****,** the end of the first actuator (**10**) which is away from the corresponding anchor pads will be lifted vertically. Consequently, the second actuator (**10'**), the support arm (**108'**) and the movable conductive member (**106'**) will be raised as well.

**FIG. 13c** shows the position of the movable conductive member (**106'**), with reference to one of the contact terminal (**104'**) once the second actuator (**10'**) is powered. Then, the voltage in the first actuator is released so that the first actuator is forced to return to its initial position. The movable conductive member (**106'**) will move downwards until it makes contact with the contact terminal (**104'**). Finally, the voltage is released from the second actuator and the free end of the second actuator will be forced to return towards its initial position at the left. This will maintain a force between the contact terminal (**104'**) and the movable conductive member (**106'**). It should be noted that all this procedure is occurring in an extremely short time and that it can be reversed by reversing the above-mentioned steps.

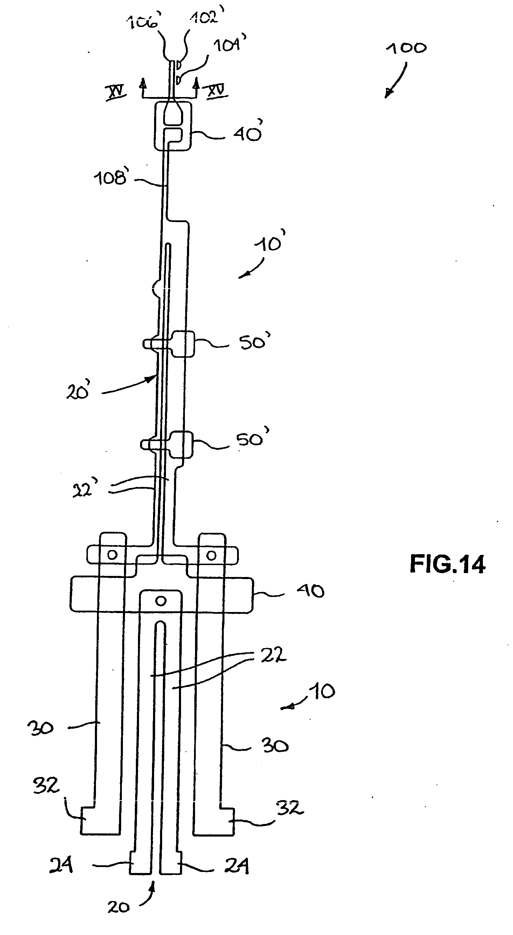

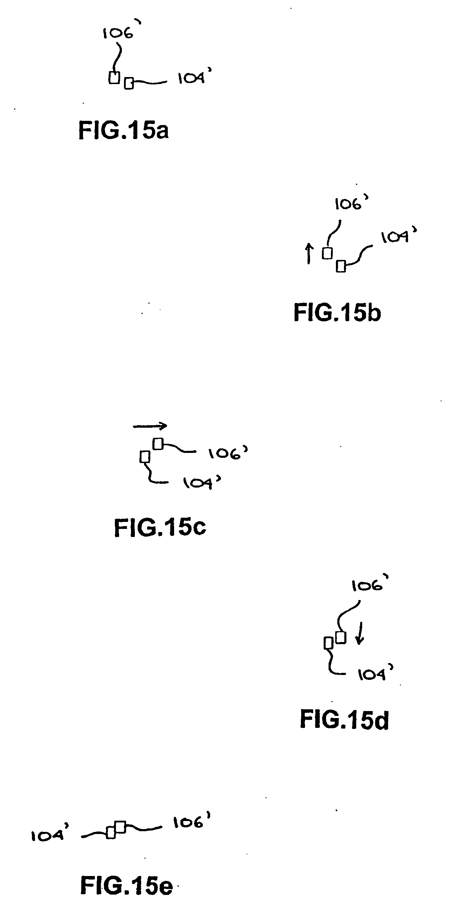

**FIG. 14** illustrates an alternative embodiment that is somewhat similar to that of **FIGS. 10** to **12**. In this embodiment, the contact terminals (**102', 104'**) do not provide a horizontal support to the movable conductive member (**106'**) when the MEMS switch (**100**) is in a closed position. **FIGS. 15a** to **15e** illustrate the various steps for closing the circuit. These steps are similar to that of **FIGS. 13a** to **13e****,** with the exception that the movable conductive member (**106'**) will not rest over the contact terminal (**104'**) when the circuit is closed.

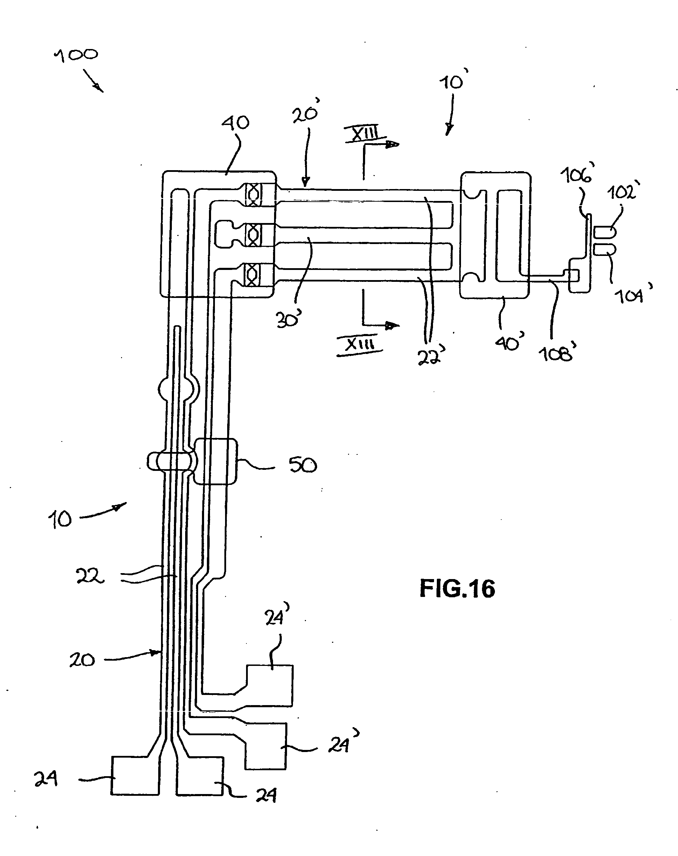

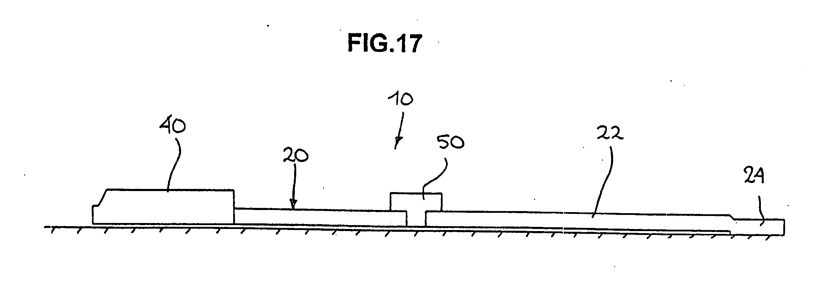

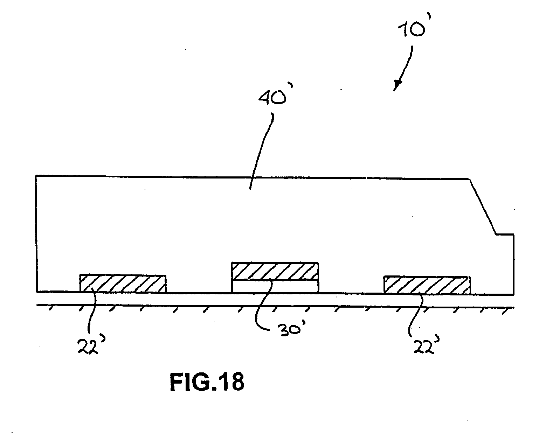

**FIGS. 16** to **18** illustrate another embodiment. In this embodiment, the first actuator (**10**) moves the movable conductive member (**106'**) in a horizontal plane. The second actuator (**10'**) moves the movable conductive member vertically. The operation of this embodiment remains similar to that illustrated in **FIGS. 13a** to **13e****,** so that the parts not referred to in this section refers to the same element in **FIGS. 10** to **14****.** **FIG. 17** shows a side view of this configuration. **FIG. 18** shows a cross-section taken along line XVIII-XVIII in **FIG.16****.**

As can be seen in **FIG. 16****,** the "cold arm member" (**30'**) can be integrated to the hot arm member (**20'**). However, since no current will flow therein, the cold arm member (**30'**) will remain at the same length when the current flows into the two portions (**22'**) of the hot arm member (**20'**). Since the two portions (**22'**) of the hot arm member (**20'**) are slightly below the level of the cold arm member (**30**), the support arm (**108'**) and the movable conductive member (**106'**) will be moved upwards.

As can be appreciated, the various configurations of the MEMS switch (**100**) disclosed herein can be designed to withstand a relatively large current between the contact terminals. Advantageously, this current may be in excess of one ampere, possibly even more. Therefore, current limiters may be omitted from the system design using this MEMS switch configuration. Typically, each actuator (**10, 10'**) is activated with a current between 50 to 200 mA. Other values are also possible.\

It is understood that the above-described embodiments are illustrative of only a few of the possible specific embodiments which can represent applications of the invention.

## Claims

1. A micro-electromechanical (MEMS) switch mounted on a substrate (12), the MEMS switch comprising:
a first cantilever MEMS actuator (10, 10') comprising a first hot arm member (20, 20') having one end (24, 24') attached to the substrate (12), first cold arm member (30, 30') having one end (32, 32') attached to the substrate (12) a first dielectric tether (40, 40') attaching together a free end (26, 26') of first hot arm member (20, 20') and a free end (34, 34') of the first cold arm member (30, 30') and a first tip member (60, 60') attached to free end (34, 34') of the first cold arm member (30, 30');
a second cantilever MEMS actuator (10, 10') comprising a second hot arm member (20, 20') having one end (24, 24') attached to the substrated (12) a second cold arm member (30, 30') having one end (32, 32') attached to the substrate (12) and a second dielectric tether (40, 40') attaching together a free end (26, 26') of the second hot arm member (20, 20') and a free end (34, 34') of the second cold arm member (30, 30') and a second tip member (60, 60') attached to the free end of the second cold arm member (30, 30'), the MEMS actuators (10, 10') being selectively movable to set the switch in either an unlatched position or a latched position, the first and the second tip members (60, 60') being mechanically latched together in the latched position; and
a pair of contact terminals (102, 104, 102', 104') provided on the substrate (12);
the MEMS switch (100) being **characterized in that** at least one of the MEMS actuators (10, 10') includes at least one support arm (108, 108') having a first end connected to the free end (34, 34') of the corresponding cold arm member (30, 30'), the support arm supporting a conductive member (106, 106') at a second end thereof, the support arm (108, 108') and its conductive member (106, 106') being configured and disposed to electrically engage both contact terminals (102, 104, 102', 104') when the switch is in the latched position, and be out of engagement with the contact terminals when the switch is in the unlatched position.

2. The MEMOS switch of claim 1, **characterized in that** the two MEMS actuators (10, 10') are positioned substantially perpendicularly with reference to each other.

3. The MEMS switch of claim 1, **characterized in that** the support arm (108, 108') includes a dielectric tether (40, 40') between the support arm (108, 108') and the conductive member (106, 106').

4. The MEMS switch of claim 1, **characterized in that** the support arm (108, 108') includes a spring portion.

5. The MEMS switch of claim 1, **characterized in that** at least two support arms (108, 108') supporting corresponding conductive members (106, 106') and at least two pairs of contact terminals (102, 104, 102', 104') are provided, a first of the support arms being connected to the first MEMS actuator (10, 10') and a second of the support arms being connected to the second MEMS (10, 10') actuator, each conductive member being selectively movable in and out of engagement with a respective one of the pairs of contact terminals (102, 104, 102', 104').

6. The MEMS switch of claim 1, **characterized in that** at least two support arms (108, 108') are provided on a same one of the MEMS actuators (10, 10').

7. The MEMS switch of claim 1, **characterized in that** the cold arm member (30, 30') of at least one of the MEMS actuators (10, 10') is angularly offset with reference to the corresponding hot arm member (20, 20').

8. The MEMS switch of claim 1, **characterized in that** at least one of the MEMS actuators (10, 10'), comprises an additional hot arm member located on an opposite side of the corresponding first or second cold arm member (30, 30') with reference to the corresponding first or second hot arm member (20, 20'), the additional hot member having one end attached to the substrate (12) and a free end attached to the corresponding first or second tether (40, 40').

9. The MEMS switch of claim 8, **characterized in that** the two hot arm members (20, 20') of the at least one of the MEMS actuators (10, 10') are electrically independent.

10. The MEMS switch of claim 8, **characterized in that** each of the two hot arm members (20, 20') of the at least one of the MEMS actuators (10, 10') has a single portion both portions being electrically connected to the cold any the free end thereof.

11. The MEMS switch of any one of claims 1 to 9, **characterized in that** each hot arm member (20, 20') includes two parallel arm portions independently connected to the substrate (12, 12') at corresponding anchor pads, and connected together at the free end (26, 26') of the hot arm member (20, 20').

12. A micro-electromechanical (MEMS) switch mounted on a substrate, the MEMS switch comprising:
- a first cantilever MEMS actuator (10,10') having one end connected to the substrate (12);
- a second cantilever MEMS actuator (10, 10') connected to a free end of the first MEMS actuator (10,10');
- one among the first and the second MEMS actuators has a vertically-movable free end, the other having a horizontally-movable free end;
- a pair of contact terminals (102, 102',104,104') provided on the substrate (12), at least one of the terminals having a projecting portion;
- at least one support arm (108,108') having a first end connected to the free end of the second MEMS actuator (10,10'), the support arm (108.108') supporting a conductive member at the second free end thereof, the support arm and its conductive member being electrically engaged with both contact terminals and mechanically latched with the projecting portion in a latched position of the switch, and being out of engagement with the contact terminals when the switch is in an unlatched position.

13. The MEMS switch of claim 12, **characterized in that** the first MEMS actuator (10, 10') has the vertically-movable free end, the first MEMS actuator (10, 10') comprising a hot arm member (20, 20') having two spaced-apart portions (22, 22'), each having a firts end (24, 24') attached to the substrate (12) and a common second end (26, 26') connected to a tether (50, 50').

14. The MEMS switch of claim 13, **characterized in that** the first MEMS actuator (10, 10') comprises two spaced-apart cold arm members (30, 30'), each having a first end attached to the substrate (12) and a second free end (34, 34') connected to the tether (50, 50') above the common second (26, 26') end of hot arm member (20, 20').

15. The MEMS switch of claim 14, **characterized in that** the second MEMS actuators (10, 10') comprises a hot arm member (20, 20') having a first end connected to the free end (34, 34') of one of the cold arm members (30, 30') of the first MEMS actuator (10, 10'), and a cold arm member (30, 30') having a first end, connected to the free end (34, 34') of the other of the cold arm members (30, 30') of the first MEMS actuator (10, 10') and a second end Connected to a second end of the hot arm member (20, 20').

16. The MEMS switch of claim 14 or 15, **characterized in that** the first MEMS actuator (10, 10') includes a dielectric tether (40, 40') between the hot arm member (20, 20') and the cold arm members (30, 30').

17. The MEMS switch of any one of claims 12 to 15, **characterized in that** it comprises a dielectric tether (120, 120') between the support arm and its conductive member (106, 106').

18. The MEMS switch of claim 12, **characterized in that** the first MEMS actuator (10, 10') comprises two spaced-apart cold arm members (30, 30'), each having a first end attached to the substrate (12) and a second free end (34, 34') connected to the tether.

19. The MEMS switch of claim 18, **characterized in that** the second MEMS actuator (10, 10'), has the vertically-movable free end, the second MEMS actuator (10, 10') comprising two spaced-apart hot arm members (20, 20'), each having a first end attached to the free end of a respective one of the cold arm members (30, 30') of the first MEMS actuator (10, 10'), and a common second end to which the support arm is connected.

## Patentansprüche

1. Mikroelektromechanischer (MEMS-) Schalter, der auf ein Substrat (12) montiert ist, wobei der MEMS-Schalter aufweist:
einen ersten MEMS-Auslegeraktuator (10, 10'), der ein erstes heißes Armelement (20, 20'), von dem ein Ende (24, 24') an dem Substrat (12) angebracht ist, ein erstes kaltes Armelement (30, 30'), von dem ein Ende (32, 32') an dem Substrat (12) angebracht ist, ein erstes dielektrisches Halteteil (40, 40'), das ein freies Ende (26, 26') des ersten heißen Armelements (20, 20') und ein freies Ende (34, 34') des ersten kalten Armelements (30, 30) aneinander anbringt, und ein erstes Spitzenelement (60, 60'), das an dem freien Ende (34, 34') des ersten kalten Armelements (30, 30') angebracht ist, aufweist;
einen zweiten MEMS-Auslegeraktuator (10, 10'), der ein zweites heißes Armelement (20, 20'), von dem ein Ende (24, 24') an dem Substrat (12) angebracht ist, ein zweites kaltes Armelement (30, 30'), von dem ein Ende (32, 32') an dem Substrat (12) angebracht ist, ein zweites dielektrisches Halteteil (40, 40'), das ein freies Ende (26, 26') des zweiten heißen Armelements (20, 20') und ein freies Ende (34, 34') des zweiten kalten Armelements (30, 30) aneinander anbringt, und ein zweites Spitzenelement (60, 60'), das an dem freien Ende (34, 34') des zweiten kalten Armelements (30, 30') angebracht ist, aufweist, wobei die MEMS-Aktuatoren (10, 10') wahlweise beweglich sind, um den Schalter entweder in eine entriegelte Position oder eine verriegelte Position zu versetzen, wobei die ersten und zweiten Spitzenelemente (60, 60') in der verriegelten Position mechanisch miteinander verriegelt sind; und
ein Paar von Kontaktanschlüssen (102, 104; 102', 104'), die auf dem Substrat (12) bereitgestellt sind;
wobei der MEMS-Schalter (100) **dadurch gekennzeichnet ist, dass** wenigstens einer der MEMS-Aktuatoren (10, 10') wenigstens einen Haltearm (108, 108') aufweist, von dem ein erstes Ende mit dem freien Ende (34, 34') des entsprechenden kalten Armelements (30, 30') verbunden ist, wobei der Haltearm ein leitendes Element (106, 106') an seinem zweiten Ende hält, wobei der Haltearm (108, 108') und sein leitendes Element (106, 106') aufgebaut und angeordnet sind, um in beide Kontaktanschlüsse (102, 104, 102', 104') elektrisch einzugreifen, wenn der Schalter in der verriegelten Position ist, und nicht in Eingriff mit den Kontaktanschlüssen zu sein, wenn der Schalter in der entriegelten Position ist.

2. MEMS-Schalter nach Anspruch 1, **dadurch gekennzeichnet, dass** die MEMS-Aktuatoren (10, 10') im Wesentlichen senkrecht in Bezug zueinander positioniert sind.

3. MEMS-Schalter nach Anspruch 1, **dadurch gekennzeichnet, dass** der Haltearm (108, 108') ein dielektrisches Halteteil (40, 40') zwischen dem Haltearm (108, 108') und dem leitenden Element (106, 106') aufweist.

4. MEMS-Schalter nach Anspruch 1, **dadurch gekennzeichnet, dass** der Haltearm (108, 108') einen Federabschnitt aufweist.

5. MEMS-Schalter nach Anspruch 1, **dadurch gekennzeichnet, dass** wenigstens zwei Haltearme (108, 108'), die entsprechende leitende Elemente (106, 106') halten, und wenigstens zwei Paare von Kontaktanschlüssen (102, 104, 102', 104') bereitgestellt sind, wobei ein erster der Haltearme mit dem ersten MEMS-Aktuator (10, 10') verbunden ist und ein zweiter der Haltearme mit dem zweiten MEMS-Aktuator (10, 10') verbunden ist, wobei jedes leitende Element wahlweise in den Eingriff mit einem jeweiligen der Paare von Kontaktanschlüssen (102, 104, 102', 104) und aus diesem heraus beweglich ist.

6. MEMS-Schalter nach Anspruch 1, **dadurch gekennzeichnet, dass** die wenigstens zwei Haltearme (108, 108') auf einem gleichen der MEMS-Aktuatoren (10, 10') bereitgestellt sind.

7. MEMS-Schalter nach Anspruch 1, **dadurch gekennzeichnet, dass** das kalte Armelement (30, 30') wenigstens eines der MEMS-Aktuatoren (10, 10') in Bezug auf das entsprechende heiße Armelement (20, 20') winkelig versetzt ist.

8. MEMS-Schalter nach Anspruch 1, **dadurch gekennzeichnet, dass** wenigstens einer der MEMS-Aktuatoren (10, 10') ein zusätzliches heißes Armelement aufweist, das sich in Bezug auf das entsprechende erste oder zweite heiße Armelement (20, 20') auf einer entgegengesetzten Seite des entsprechenden ersten oder zweiten kalten Armelements (30, 30') befindet, wobei das zusätzliche heiße Armelement ein an dem Substrat (12) angebrachtes Ende und ein an dem entsprechenden ersten oder zweiten Halteteil (40, 40') angebrachtes freies Ende hat.

9. MEMS-Schalter nach Anspruch 8, **dadurch gekennzeichnet, dass** die zwei heißen Armelemente (20, 20') des wenigstens einen der MEMS-Aktuatoren (10, 10') elektrisch unabhängig sind.

10. MEMS-Schalter nach Anspruch 8, **dadurch gekennzeichnet, dass** jedes der zwei heißen zwei Armelemente (20, 20') des wenigstens einen der MEMS-Aktuatoren einen einzelnen Abschnitt hat, wobei beide Abschnitte an dessen freiem Ende mit dem kalten Armelement verbunden sind.

11. MEMS-Schalter nach einem der Ansprüche 1 bis 9, **dadurch gekennzeichnet, dass** jedes heiße Armelement (20, 20') zwei parallele Armabschnitte aufweist, die an entsprechenden Verankerungsunterlagen unabhängig mit dem Substrat (12, 12') verbunden sind und an dem freien Ende (26, 26') des heißen Armelements (20, 20') miteinander verbunden sind.

12. Mikroelektromechanischer (MEMS-) Schalter, der auf ein Substrat montiert ist, wobei der MEMS-Schalter aufweist:
- einen ersten MEMS-Auslegeraktuator (10, 10'), von dem ein Ende mit dem Substrat (12) verbunden ist;
- einen zweiten MEMS-Auslegeraktuator (10, 10'), der mit einem freien Ende des ersten MEMS-Aktuators (10, 10') verbunden ist;
- wobei einer der ersten und zweiten MEMS-Aktuatoren ein vertikal bewegliches freies Ende hat und der andere ein horizontal bewegliches freies Ende hat;
- ein Paar von Kontaktanschlüssen (102, 102', 104, 104'), die auf dem Substrat (12) an wenigstes einem der Anschüsse mit einem vorstehenden Abschnitt bereitgestellt sind;
- wenigstens einen Haltearm (108, 108') mit einem ersten Ende, das mit dem freien Ende des zweiten MEMS-Aktuators (10, 10') verbunden ist, wobei der Haltearm (108, 108') ein leitendes Element an seinem zweiten freien Ende hält, wobei der Haltearm und sein leitendes Element mit beiden Kontaktanschlüssen elektrisch in Eingriff sind und in einer verriegelten Position des Schalters mit dem vorstehenden Abschnitt mechanisch verriegelt sind und, wenn der Schalter in einer entriegelten Position ist, nicht in Eingriff mit den Kontaktanschlüssen sind.

13. MEMS-Schalter nach Anspruch 12, **dadurch gekennzeichnet, dass** der erste MEMS-Aktuator (10, 10') das vertikal bewegliche freie Ende hat, wobei der erste MEMS-Aktuator (10, 10') ein heißes Armelement (20, 20') mit zwei beabstandeten Abschnitten (22, 22') aufweist, wobei jeder Abschnitt ein an dem Substrat (12) angebrachtes erstes Ende (24, 24') und ein mit einem Haltebügel (50, 50') verbundenes gemeinsames zweites Ende (26, 26') hat.

14. MEMS-Schalter nach Anspruch 13, **dadurch gekennzeichnet, dass** der erste MEMS-Aktuator (10, 10') zwei beabstandete kalte Armelemente (30, 30') aufweist, von denen jedes ein an dem Substrat (12) angebrachtes erstes Ende und ein mit dem Halteteil (50, 50') über dem gemeinsamen zweiten Ende (26, 26') des heißen Armelements (20, 20') zweites freies Ende (34, 34') hat.

15. MEMS-Schalter nach Anspruch 14, **dadurch gekennzeichnet, dass** der zweite MEMS-Aktuator (10, 10') ein heißes Armelement (20, 20') mit einem ersten Ende, das mit dem freien Ende (31, 31') eines der kalten Armelemente (30, 30') des ersten MEMS-Aktuators (10, 10') verbunden ist, und ein kaltes Armelement (30, 31') mit einem Ende, das mit dem freien Ende (34, 34') des anderen der kalten Armelemente (30, 30') des ersten MEMS-Aktuators (10, 10') verbunden ist, und einem zweiten Ende, das mit einem zweiten Ende des heißen Armelements (20, 20') verbunden ist, aufweist.

16. MEMS-Schalter nach Anspruch 14 oder 15, **dadurch gekennzeichnet, dass** der erste MEMS-Aktuator (10, 10') ein dielektrisches Halteteil (40, 40') zwischen dem heißen Armelement (20, 20') und den kalten Armelementen (30, 30') aufweist.

17. MEMS-Schalter nach einem der Ansprüche 12 bis 15, **dadurch gekennzeichnet, dass** er ein dielektrisches Halteteil (120, 120') zwischen dem Haltearm und seinem leitenden Element (106, 106') aufweist.

18. MEMS-Schalter nach Anspruch 12, **dadurch gekennzeichnet, dass** der erste MEMS-Aktuator (10, 10') zwei beabstandete kalte Armelemente (30, 30') aufweist, von denen jedes ein an dem Substrat (12) angebrachtes erstes Ende und ein mit dem Haltebügel verbundenes zweites freies Ende (34, 34') hat.

19. MEMS-Schalter nach Anspruch 18, **dadurch gekennzeichnet, dass** der zweite MEMS-Aktuator (10, 10') das vertikal bewegliche freie Ende hat, wobei der zweite MEMS-Aktuator (10, 10') zwei beabstandete heiße Armelemente (20, 20') aufweist, von denen jedes ein erstes an dem freien Ende eines jeweiligen der kalten Armelemente (30, 30') des ersten MEMS-Aktuators (10, 10') angebrachtes Ende und ein mit dem der Haltearm verbundenes gemeinsames zweites Ende hat.

## Revendications

1. Commutateur micro-électro-mécanique (MEMS) monté sur un substrat (12), le commutateur MEMS comprenant :
un premier actionneur MEMS en porte à faux (10, 10') comprenant un premier élément de bras chaud (20, 20') ayant une extrémité (24, 24') fixée au substrat (12), un premier élément de bras froid (30, 30') ayant une extrémité (32, 32') fixée au substrat (12), une première attache diélectrique (40, 40') fixant ensemble une extrémité libre (26, 26') du premier élément de bras chaud (20, 20') et une extrémité libre (34, 34') du premier élément de bras froid (30, 30') et un premier élément de pointe (60, 60') fixé à l'extrémité libre(34, 34') du premier élément de bras froid (30, 30') ;
un deuxième actionneur MEMS en porte à faux (10, 10') comprenant un deuxième élément de bras chaud (20, 20') ayant une extrémité (21, 21') fixée au substrat (12), un deuxième élément de bras froid (30, 30') ayant une extrémité (32, 32') fixée au substrat (12), une deuxième attache diélectrique (40, 40') fixant ensemble une extrémité libre (26, 26') du deuxième élément de bras chaud (20, 20') et une extrémité libre (34, 34') du deuxième élément de bras froid (30, 30') et un deuxième élément de pointe (60, 60') fixé à l'extrémité libre(34, 34') du deuxième élément de bras froid (30, 30'), les actionneurs MEMS (10, 10') étant déplaçables sélectivement pour mettre le commutateur dans une position déverrouillée ou une position verrouillée, les premier et deuxième éléments de pointe (60, 60') étant verrouillés mécaniquement ensemble dans la position verrouillée ; et
une paire de bornes de contact (102, 104 ; 102', 104') prédisposée sur le substrat (12) ;
le commutateur MEMS (100) étant **caractérisé en ce qu'**au moins un des actionneurs MEMS (10, 10') comprend au moins un bras de support (108, 108') ayant une première extrémité connectée à l'extrémité libre (34, 34') de l'élément de bras froid correspondant (30, 30'), le bras de support supportant un élément conducteur (106, 106') à une deuxième extrémité de celui-ci, le bras de support (108, 108') et son élément conducteur (106, 106') étant configurés et disposés pour engager électriquement les deux bornes de contact (102, 104 ; 102', 104') quand le commutateur est dans la position verrouillée et être hors engagement avec les bornes de contact quand le commutateur est dans la position déverrouillée.

2. Commutateur MEMS selon la revendication 1, **caractérisé en ce que** les deux actionneurs MEMS (10, 10') sont positionnés sensiblement de manière perpendiculaire l'un par rapport à l'autre.

3. Commutateur MEMS selon la revendication 1, **caractérisé en ce que** le bras de support (108, 108') comprend une attache diélectrique (40, 40') entre le bras de support (108, 108') et l'élément conducteur (106, 106').

4. Commutateur MEMS selon la revendication 1, **caractérisé en ce que** le bras de support (108, 108') comprend une portion à ressort.

5. Commutateur MEMS selon la revendication 1, **caractérisé en ce qu'**au moins deux bras de support (108, 108') supportant des éléments conducteurs correspondants (106, 106') et au moins deux paires de bornes de contact (102, 104 ; 102', 104') sont prévus, un premier des bras de support étant connecté au premier actionneur MEMS (10, 10') et un deuxième des bras de support étant connecté au deuxième actionneur MEMS (10, 10'), chaque élément conducteur étant mobile sélectivement en et hors engagement avec l'une respective des paires de bornes de contact (102, 104 ; 102', 104').

6. Commutateur MEMS selon la revendication 1, **caractérisé en ce qu'**au moins deux bras de support (108, 108') sont prédisposés sur un même actionneur MEMS (10, 10') parmi les actionneurs MEMS.

7. Commutateur MEMS selon la revendication 1, **caractérisé en ce que** l'élément de bras froid (30, 30') d'au moins un des actionneurs MEMS (10, 10') est décalé angulairement par rapport à l'élément de bras chaud (20, 20') correspondant.

8. Commutateur MEMS selon la revendication 1, **caractérisé en ce qu'**au moins un des actionneurs MEMS (10, 10') comprend un élément de bras chaud additionnel situé sur un côté opposé du premier ou deuxième élément de bras froid (30, 30') correspondant par rapport au premier ou deuxième élément de bras chaud (20, 20') correspondant, l'élément de bras chaud additionnel ayant une extrémité fixée au substrat (12) et une extrémité libre fixée à la première ou deuxième attache (40, 40') correspondante.

9. Commutateur MEMS selon la revendication 8, **caractérisé en ce que** les deux éléments de bras chaud (20, 20') de l'au moins un des actionneurs MEMS (10, 10') sont indépendants électriquement.

10. Commutateur MEMS selon la revendication 8, **caractérisé en ce que** chacun des deux éléments de bras chaud (20, 20') de l'au moins un des actionneurs MEMS (10, 10') a une potion individuelle, les deux portions étant connectées électriquement à l'élément de bras froid à l'extrémité libre de celui-ci.

11. Commutateur MEMS selon l'une quelconque des revendications 1 à 9, **caractérisé en ce que** chaque élément de bras chaud (20, 20') comprend deux portions de bras parallèles connectées indépendamment au substrat (12, 12') au niveau de pastilles d'ancrage correspondantes et connectées ensemble à l'extrémité libre (26, 26') de l'élément de bras chaud (20, 20').

12. Commutateur micro-électro-mécanique (MEMS) monté sur un substrat, le commutateur MEMS comprenant :
- un premier actionneur MEMS en porte à faux (10, 10') ayant une extrémité connecté au substrat (12) ;
- un deuxième actionneur MEMS en porte à faux (10, 10') connecté à une extrémité libre du premier actionneur MEMS (10, 10') ;
- un parmi les premier et deuxième actionneurs MEMS a une extrémité libre mobile verticalement, l'autre ayant une extrémité libre mobile horizontalement ;
- une paire de bornes de contact (102, 102' ; 104, 104') prédisposée sur le substrat (12), au moins une des bornes ayant une portion en saillie ;
- au moins un bras de support (108, 108') ayant une première extrémité connectée à l'extrémité libre du deuxième actionneur MEMS (10, 10'), le bras de support (108, 108') supportant un élément conducteur au niveau de la deuxième extrémité libre de celui-ci, le bras de support et son élément conducteur étant engagés électriquement avec les deux bornes de contact et verrouillées mécaniquement avec la portion en saillie dans une position verrouillée du commutateur et étant hors engagement avec les bornes de contact quand le commutateur est dans une position déverrouillée.

13. Commutateur MEMS selon la revendication 12, **caractérisé en ce que** le premier actionneur MEMS (10, 10') a l'extrémité libre mobile verticalement, le premier actionneur MEMS (10, 10') comprenant un élément de bras chaud (20, 20') ayant deux portions écartées (22, 22'), chacune ayant une première extrémité (24, 24') fixée au substrat (12) et une deuxième extrémité commune (26, 26') connectée à une attache (50, 50').

14. Commutateur MEMS selon la revendication 13, **caractérisé en ce que** le premier actionneur MEMS (10, 10') comprend deux éléments de bras froid écartés (30, 30'), chacun ayant une première extrémité fixée au substrat (12) et une deuxième extrémité libre (34, 34') connectée à l'attache (50, 50') au-dessus de la deuxième extrémité commune (26, 26') de l'élément de bras chaud (20, 20').

15. Commutateur MEMS selon la revendication 14, **caractérisé en ce que** le deuxième actionneur MEMS (10, 10') comprend un élément de bras chaud (20, 20') ayant une première extrémité connectée à l'extrémité libre (31, 31') d'un des éléments de bras froid (30, 30') du premier actionneur MEMS (10, 10') et un élément de bras froid (30, 30') ayant une première extrémité connectée à l'extrémité libre (34, 34') de l'autre élément de bras froid (30, 30') du premier actionneur MEMS (10, 10') et une deuxième extrémité connectée à une deuxième extrémité de l'élément de bras chaud (20, 20').

16. Commutateur MEMS selon la revendication 14 ou 15, **caractérisé en ce que** le premier actionneur MEMS (10, 10') comprend une attache diélectrique (40, 40') entre l'élément de bras chaud (20, 20') et les éléments de bras froid (30, 30').

17. Commutateur MEMS selon l'une quelconque des revendications 12 à 15, **caractérisé en ce qu'**il comprend une attache diélectrique (120, 120') entre le bras de support et son élément conducteur (106, 106').

18. Commutateur MEMS selon la revendication 12, **caractérisé en ce que** le premier actionneur MEMS (10, 10') comprend deux éléments de bras froid écartés (30, 30'), chacun ayant une première extrémité fixée au substrat (12) et une deuxième extrémité libre (34, 34') connectée à l'attache.

19. Commutateur MEMS selon la revendication 18, **caractérisé en ce que** le deuxième actionneur MEMS (10, 10') a l'extrémité libre mobile verticalement, le deuxième actionneur MEMS (10, 10') comprenant deux éléments de bras chaud écartés (20, 20'), chacun ayant une première extrémité fixée à l'extrémité libre de l'un respectif des éléments de bras froid (30, 30') du premier actionneur MEMS (10, 10') et une deuxième extrémité commune à laquelle le bras de support est connecté.
